# EUROPEAN PATENT SPECIFICATION

(11) **EP 2 978 297 B1**
(45) Date of publication and mention of the grant of the patent: **25.10.2017**
(21) Application number: 13879234.6
(22) Date of filing: 19.03.2013
(51) Int. Cl.: H05K 13/04

(54) **COMPONENT MOUNTING DEVICE**
KOMPONENTENMONTAGEVORRICHTUNG
DISPOSITIF DE MONTAGE DE COMPOSANT

(43) Date of publication of application: 27.01.2016
(73) Proprietor: Fuji Machine Mfg. Co., Ltd., Chiryu-shi, Aichi 472-8686 (JP)
(72) Inventor: FUJITA Masatoshi, Chiryu-shi Aichi 472-8686 (JP); KIDO Takashi, Chiryu-shi Aichi 472-8686 (JP); NAGATA Ryo, Chiryu-shi Aichi 472-8686 (JP); KAINUMA Makoto, Chiryu-shi Aichi 472-8686 (JP)
(74) Representative: Grünecker Patent- und Rechtsanwälte PartG mbB
(86) International application number: PCT/JP2013/057912
(87) International publication number: WO 2014/147770

(56) References cited:
- DE-A1- 10 304 970
- JP-A- 2005 340 780
- JP-A- 2006 278 627
- JP-A- 2008 091 856
- JP-A- 2008 091 856
- JP-A- 2011 249 704
- JP-A- 2012 129 434
- US-A1- 2009 224 717

## Description

### Technical Field

The present invention relates to a component mounting device which mounts a component on a board.

### Background Art

A component mounting device mounts a component on a board by causing a suction section such as a suction nozzle to suck the component. In order to improve accuracy in mounting the component on the board, it is necessary to improve positioning accuracy of a distal end of the suction section. The suction section is moved by X and Y robots. However, the suction section is forced to vibrate due to the movement of the suction section.

Therefore, in the related art, vibrations of the suction section are suppressed by performing feedback control. However, there is a problem that the vibrations of the suction section cannot be sufficiently suppressed even if the feedback control is performed.

Therefore, as disclosed in PTL 1, a technique has been proposed in which acceleration of a main body of a component mounting device is detected so as to perform the feedforward control on a movement of the suction section, based on the acceleration.

PTL 2 discloses a positioning unit for attachment to a moving element of an industrial robot comprises: a housing, shaft, rotating drive, linear drive and a mounting element that is attached to the shaft where it extends from the housing. A force sensor is coupled to the shaft and measures counter forces acting along the shaft axis that are applied against the mounting element. The force sensor output is delivered to the linear drive so that its speed, acceleration and or drive force can be adjusted accordingly.

PTL 3 discloses an electronic component mounting apparatus capable of high speed mounting of components with high accuracy while suppressing vibration of a suction nozzle part. Sensors are provided for detecting the acceleration of a suction nozzle part, and driving control of a driving shaft, where vibration of the suction nozzle part is suppressed by a motor control device of the driving shaft, is performed by an acceleration signal detected by the sensor. The motor control device can feedback a load side disturbance through a reverse system from load side disturbance to a position command value. The load side disturbance is estimated by a load side disturbance observer which is constructed using the acceleration signal detected by the sensor for compensating disturbance including variation of the load and variation of parameters. Further, the motor control device implements phase lead compensation by setting a nominal value of motor inertia used in the disturbance observer larger than the actual motor inertia.

PTL 4 discloses an operating apparatus including a main body, a movable member, a drive unit having a drive source, and a control unit controlling the drive source to control the position of the movable member relative to the main body. The control unit including a position control system and an acceleration control system. The position control system including a position command portion, a first feedforward compensator outputting a first operation command to the drive source, a second feedforward compensator, a positional-information acquiring device obtaining information related to the position of the movable member, and a first feedback compensator outputting a second operation command to the drive source.; The acceleration control system including an acceleration-information acquiring device obtaining information related to an acceleration of the main body, a third feedforward compensator, a second feedback compensator outputting a third operation command to the drive source.

### Citation List

### Patent Literature

PTL 1: JP-A-2009-217329
PTL 2: DE 103 04 970 A1
PTL 3: JP 2008 091856 A
PTL 4: US 2009/224717 A1

### Summary of Invention

### Technical Problem

However, according to the technique disclosed in PTL 1, only the acceleration of the main body of the component mounting device can be obtained. For this reason, the feedforward control is performed on the movement of the suction section, based on the acceleration of the main body of the component mounting device which is not the suction section. Consequently, there is a problem that the vibrations of the suction section cannot be sufficiently suppressed.

The invention is made in view of the above-described circumstances, and an object thereof is to provide a component mounting device which can acquire acceleration of a suction section.

### Solution to Problem

In order to solve the above-described problem, a component mounting device according to the invention disclosed in Claim 1 includes a base, a suction section that sucks a component, and that mounts the component on a board, a suction section moving device that is provided on the base, and that moves the suction section, and an acceleration acquisition section that acquires acceleration of a site of the suction section when the suction section moving device moves the suction section.

According to this configuration, it is possible to provide the component mounting device which can acquire the acceleration of the suction section. Then, since the acceleration acquisition section acquires the acceleration of the site of the suction section when the suction section is moved, the acceleration of the site of the suction section is analyzed. In this manner, it is possible to obtain information which is helpful in suppressing the vibrations of the suction section, such as natural frequency of the site of the suction section. Therefore, it is possible to perform control for suppressing the vibrations of the suction section, based on the information.

Furthermore, in the invention disclosed in Claim 1, the suction section is configured to include a suction nozzle which sucks the component and a suction head which is attached to the suction section moving device by attaching the suction nozzle thereto, and the acceleration acquisition section is attached to the suction head so as to be replaceable with the suction nozzle.

As described above, the acceleration acquisition section is attached to the suction head so as to be replaceable with the suction nozzle. In this manner, it is possible to easily acquire the acceleration of the site of the suction section by attaching the acceleration acquisition section to the suction head in place of the suction nozzle.

Furthermore, in the invention disclosed in Claim 1, the suction section is configured to include a suction nozzle which sucks the component and a suction head which is attached to the suction section moving device by attaching the suction nozzle thereto, and the acceleration acquisition section is attached to the suction section moving device so as to be replaceable with the suction head.

As described above, the acceleration acquisition section is attached to the suction section moving device so as to be replaceable with the suction head. In this manner, it is possible to easily acquire the acceleration of the site of the suction section by attaching the acceleration acquisition section to the suction section moving device in place of the suction head.

According to the invention disclosed in Claim 2, in the invention disclosed in Claim 1, the acceleration acquisition section is detachably attached to the base or a member which is integrally attached to the base.

According to this configuration, it is possible to easily attach the acceleration acquisition section to the base or the member which is integrally attached to the base. Therefore, it is possible to easily acquire the acceleration on the base side when the suction section is moved. Then, the acceleration on the base side is analyzed. In this manner, it is possible to obtain information which is helpful in suppressing the vibrations of the suction section, such as natural frequency on the base side. Therefore, it is possible to perform control for further suppressing the vibrations of the suction section, based on the information which is helpful in suppressing the vibrations of the suction section on the base side together with the information which is helpful in suppressing the vibrations of the suction section in the site of the suction section.

According to the invention disclosed in Claim 3, in the invention disclosed in Claim 1, a board conveyance device which conveys the board is attached to the base, and the board conveyance device can convey the acceleration acquisition section.

According to this configuration, the board conveyance device is caused to convey the acceleration acquisition section so as to stop inside the component mounting device, and the suction section moving device is caused to move the suction section. In this manner, it is possible to easily acquire the acceleration on the base side when the suction section is moved. Then, the acceleration on the base side is analyzed. In this manner, it is possible to obtain information which is helpful in suppressing the vibrations of the suction section, such as natural frequency on the base side. Therefore, it is possible to perform control for further suppressing the vibrations of the suction section, based on the information which is helpful in suppressing the vibrations of the suction section on the base side together with the information which is helpful in suppressing the vibrations of the suction section in the site of the suction section.

According to the invention disclosed in Claim 4, in the invention disclosed in any one of Claims 1 to 3, the component mounting device further includes a vibration analysis section that analyzes vibrations generated by the movement of the suction section, based on acceleration acquired by the acceleration acquisition section, when the suction section moving device moves the suction section, and a vibration suppressing section that controls the suction section moving device so as to suppress the vibrations, based on a result of analysis performed by the vibration analysis section. According to this configuration, it is possible to suppress the vibrations of the suction section which are generated due to the movement of the suction section.

### Brief Description of Drawings

[Fig. 1] Fig. 1 is a perspective view of a component mounting device.
[Fig. 2] Fig. 2 is a view for schematically describing a portion of a nozzle holder of a suction head, a suction nozzle, and a pressure source.
[Fig. 3] Fig. 3 is a perspective view of an acceleration acquisition member.
[Fig. 4] Fig. 4 is a flowchart illustrating a first natural frequency acquisition process according to a first embodiment.
[Fig. 5] Fig. 5 is a flowchart illustrating a first natural frequency acquisition process according to a second embodiment.
[Fig. 6] Fig. 6 is a flowchart illustrating a second natural frequency acquisition process according to the first embodiment.
[Fig. 7] Fig. 7 is a flowchart illustrating a second natural frequency acquisition process according to the second embodiment.
[Fig. 8] Fig. 8 is a block diagram illustrating a vibration suppressing section.
[Fig. 9] Fig. 9 is a perspective view illustrating an acceleration acquisition member according to another embodiment.

### Description of Embodiments

### (Component Mounting Device)

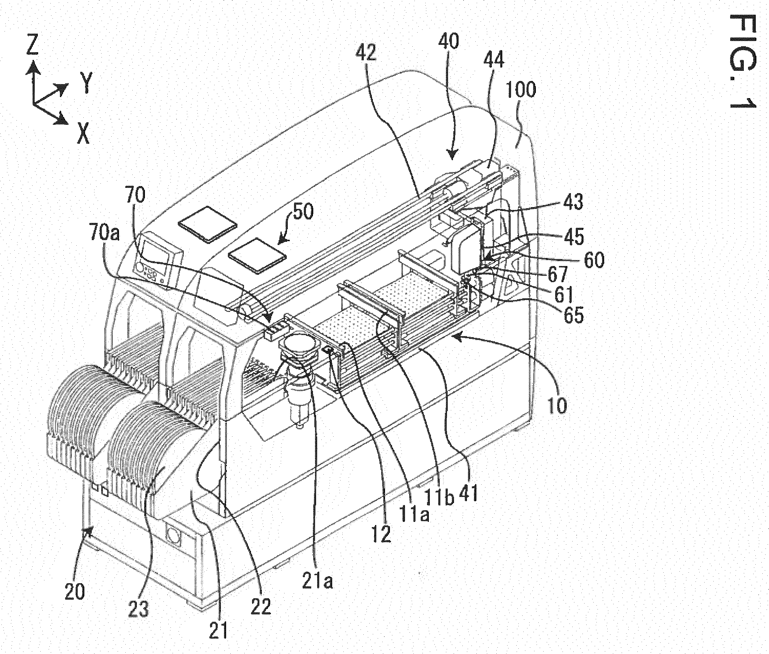

Hereinafter, a component mounting device 100 will be described with reference to Fig. 1. As illustrated in Fig. 1, the component mounting device 100 has a board conveyance device 10, a component supply device 20, a component mounting section 40, a control section 50, and a nozzle accommodating member 70. In the following description, a conveyance direction of a board is referred to as an X-axis direction. Then, a direction which is orthogonal to the X-axis direction in a horizontal plane is referred to as a Y-axis direction. In addition, a vertical direction which is orthogonal to the X-axis direction and the Y-axis direction is referred to as a Z-axis direction.

Multiple slots 22 are arrayed in a front section of the component mounting device 100 in the X-axis direction. The component supply device 20 is configured to include multiple feeders 21 which are detachably mounted on the respective slots 22. A reel 23 is detachably held in the feeder 21. A tape which accommodates many components in a row is wound around the reel 23.

A sprocket (not illustrated) is rotatably supported inside the feeder 21. An outer peripheral portion of the sprocket engages with a feed hole which is formed in the tape. A servo motor (not illustrated) which serves as a drive source for rotating the sprocket is disposed in the feeder 21.

The tape wound around the reel 23 is fed one pitch by one pitch by the sprocket being rotated. Then, the components accommodated in the tape are sequentially supplied to a component supply section 21a which is disposed in a distal end portion of the feeder 21.

The board conveyance device 10 sequentially conveys boards to the component mounting device 100 located on the downstream side in the X-axis direction, and positions and fixes (clamps) the boards at a mounting position inside the component mounting device 100 to which the board are conveyed. In the present embodiment, two board conveyance devices 10 are arrayed on a base 41 of the component mounting section 40 in the Y-axis direction. The board conveyance device 10 has a pair of guide rails 11a and 11b and a pair of conveyor belts (not illustrated).

The guide rails 11a and 11b are respectively and horizontally arrayed so as to oppose each other in parallel to each other on the base 41. The pair of conveyor belts are arranged inside the pair of guide rails 11a and 11b. The boards respectively guided by the guide rails 11a and 11b are supported and conveyed by the pair of conveyor belts.

The respective component mounting devices 100 are arranged adjacent to each other so that the board conveyance device 10 is continuous in the X-axis direction. Then, the board conveyance devices 10 of the respective component mounting devices 100 are operated while being interlocked with each other, and sequentially feed the respective boards on the board conveyance device 10 located on the downstream side so as to position and hold the boards at a predetermined position.

An attachment portion 12 is attached to the board conveyance device 10. The attachment portion 12 has plate shape or a block shape which has a horizontal plane on an upper end thereof, and is configured to include a soft magnetic material such as iron whose magnetic permeability is significant.

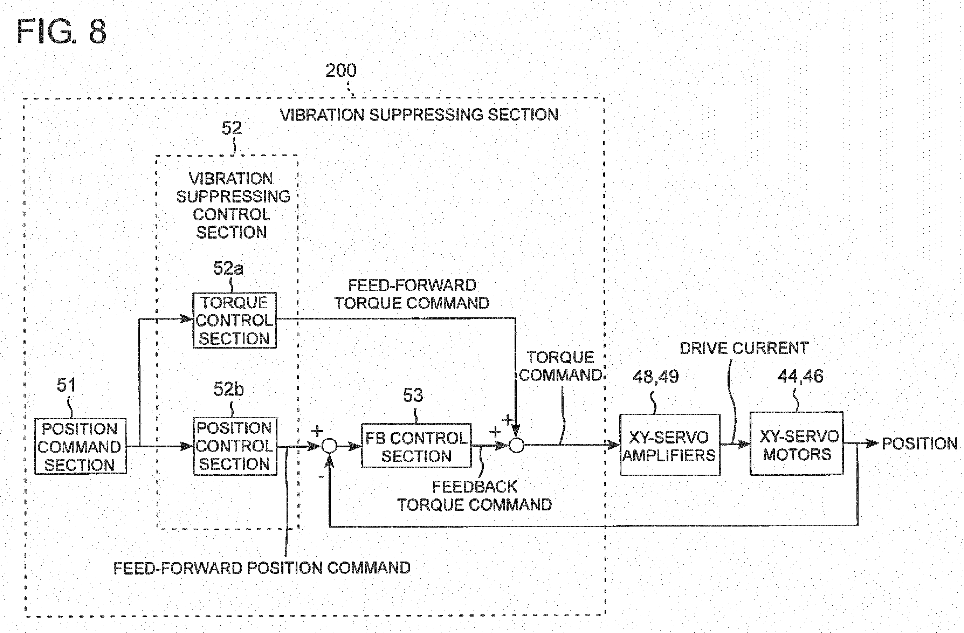

The component mounting section 40 has a guide rail 42, a Y-axis slide 43, a Y-servo motor 44, an X-axis slide 45, an X-servo motor 46 (refer to Fig. 8), an X-servo amplifier 48 (refer to Fig. 8), a Y-servo amplifier 49 (refer to Fig. 8), a suction nozzle 65, and a suction head 60.

A Y robot is configured to include the guide rail 42, the Y-axis slide 43, the Y-servo motor 44, and the Y-servo amplifier 49. The guide rail 42 is installed on the base 41 in the Y-axis direction, and is arranged above the board conveyance device 10. The Y-axis slide 43 is disposed so as to be movable along the guide rail 42 in the Y-axis direction. The Y-axis slide 43 is moved in the Y-axis direction by a ball screw mechanism having a ball screw connected to an output shaft of the Y-servo motor 44.

An X robot is configured to include the X-axis slide 45, the X-servo motor 46, and the X-servo amplifier 48. The X-axis slide 45 is disposed in the Y-axis slide 43 so as to be movable in the X-axis direction. The X-servo motor 46 is disposed in the Y-axis slide 43. The X-axis slide 45 is moved in the X-axis direction by a ball screw mechanism (not illustrated) connected to an output shaft of the X-servo motor 46. A "suction section moving device" disclosed in Claims is configured to include the X robot and the Y robot which are described above.

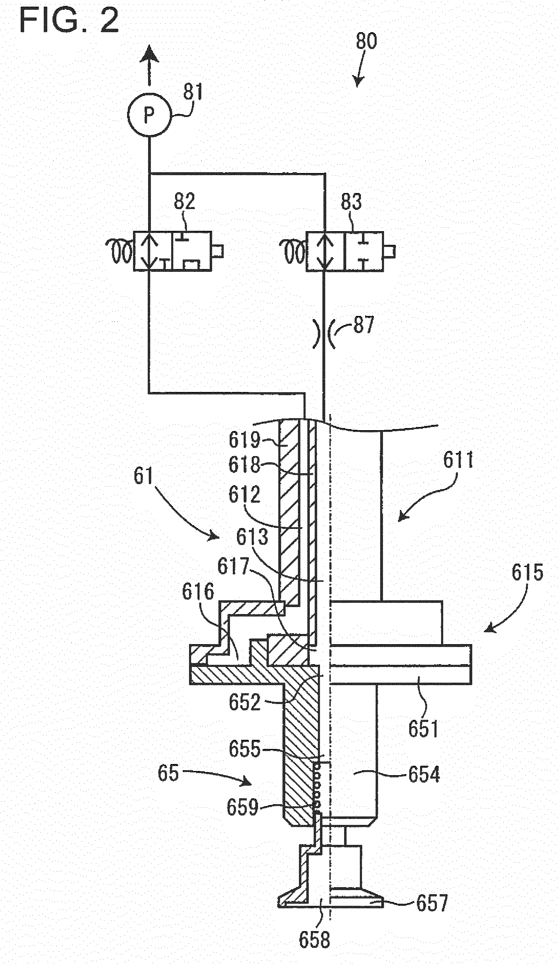

The suction head 60 is detachably attached to the X-axis slide 45. Hereinafter, the suction head 60 and the suction nozzle 65 will be described with reference to Figs. 1 and 2. As illustrated in Fig. 1, a single or multiple nozzle holders 61 protruding downward and an imaging device 67 are disposed in the suction head 60. The suction nozzle 65 is detachably attached to the nozzle holder 61.

As illustrated in Fig. 2, the nozzle holder 61 is configured to include a support body section 611 and a nozzle mounting section 615. The support body section 611 is configured to include an inner tube 618 and an outer tube 619 which is arranged outside the inner tube 618 so as to be coaxial with the inner tube 618. A negative pressure air flow path 612 to which negative pressure air is supplied is arranged between the inner tube 618 and the outer tube 619. An air flow path 613 to which negative pressure air is supplied is arranged inside the inner tube 618.

The nozzle mounting section 615 is coupled with the lower side of the support body section 611, and a lower surface thereof has a plane shape. The negative pressure air flow path 612 communicates with a nozzle suction hole 616 which is open downward from the vicinity of the lower surface of the nozzle mounting section 615. In addition, the air flow path 613 located on the inner side communicates with a supply hole 617 which is open downward from the center of the lower surface of the nozzle mounting section 615.

The suction nozzle 65 is configured to include a mounting base 651, a connection portion 654, and a suction portion 657. The mounting base 651 has a disk shape. A supply hole 652 penetrating in a vertical direction is formed in the center of the mounting base 651. The mounting base 651 is arranged so as to oppose the nozzle mounting section 615 of the nozzle holder 61. Then, an upper surface of the mounting base 651 is sucked by the nozzle suction hole 616 of the nozzle mounting section 615. The supply hole 652 of the mounting base 651 is adapted to communicate with the supply hole 617 of the nozzle mounting section 615.

The connection portion 654 has a cylindrical shape. The connection portion 654 is coupled with the lower side of the mounting base 651, and extends downward. An air flow path 655 which communicates with the supply hole 652 of the mounting base 651 is formed on an inner peripheral side of the connection portion 654.

The suction portion 657 is arranged on the lower side of the connection portion 654 so as to be vertically movable relative to the connection portion 654. A suction hole 658 penetrating in the vertical direction is formed in the center of the suction portion 657. The suction hole 658 communicates with the air flow path 655 of the connection portion 654. In addition, a spiral spring member 659 is held on the inner peripheral side of the connection portion 654. The spring member 659 biases the suction portion 657 so as to be separated downward from the mounting base 651. When the suction portion 657 sucks the component while being in contact with the component, the spring member 659 is relatively raised from the connection portion 654. In this manner, the spring member 659 is adapted to lessen an impulsive force applied to the component.

A pressure source 80 is a drive source when the suction nozzle 65 sucks and mounts the component. The pressure source 80 illustrated in Fig. 2 is configured to include a vacuum pump 81 and two electromagnetic valves 82 and 83.

The suction side of the vacuum pump 81 shows negative pressure. This negative pressure air is supplied to the negative pressure air flow path 612 of the support body section 611 of the nozzle holder 61 via the electromagnetic valve 82 in a communicating state, and is further supplied to the nozzle suction hole 616 of the nozzle mounting section 615. In this manner, the nozzle holder 61 can attach the suction nozzle 65 to the nozzle mounting section 615 by sucking the suction nozzle 65. In addition, if the negative pressure is released by the electromagnetic valve 82, the negative pressure air flow path 612 and the nozzle suction hole 616 are exposed to the atmosphere. In this manner, the suction nozzle 65 is detached from the nozzle mounting section 615.

Furthermore, the negative pressure air is supplied to the air flow path 613 of the support body section 611 of the nozzle holder 61 via the electromagnetic valve 83 in a communicating state byway of a fixed throttle 87. The negative pressure air is supplied to the suction hole 658 of the suction portion 657 from the supply hole 617 of the nozzle mounting section 615 via the supply hole 652 of the mounting base 651 of the suction nozzle 65 and the air flow path 655 of the connection portion 654. In this manner, the suction nozzle 65 can suck the component by using the suction portion 657.

The imaging device 67 images a lower side of the suction head 60, and outputs a captured image to the control section 50.

The control section 50 performs overall control of the component mounting device 100. The control section 50 has a "memory section" configured to include a CPU, a RAM, a ROM, and a nonvolatile memory (all not illustrated). The CPU executes a program. The RAM temporarily stores variables required for executing the program. The "memory section" stores the above-described program. The control section 50 outputs commands to the feeder 21, the board conveyance device 10, the respective servo motors of the component mounting section 40, the vacuum pump 81, and the electromagnetic valves 82 and 83, and controls all of these.

The nozzle accommodating member 70 is disposed between the component supply device 20 and the board conveyance device 10. According to the present embodiment, the nozzle accommodating member 70 is attachable and detachable. Multiple accommodating portions 70a are formed on an upper surface of the nozzle accommodating member 70. The suction nozzle 65 having multiple types is accommodated in the accommodating portion 70a. The X robot and the Y robot move the suction head 60 to the nozzle accommodating member 70. In this manner, the suction nozzle 65 attached to the suction head 60 can be detached and accommodated in the accommodating portion 70a, and the suction nozzle 65 accommodated in the accommodating portion 70a can be replaced by being mounted on the suction head 60.

The suction nozzle 65 is moved onto the component supply section 21a by the Y robot and the X robot, and the suction nozzle 65 sucks the component supplied to the component supply section 21a. Then, the suction nozzle 65 is moved onto the board conveyance device 10 by the Y robot and the X robot, and the suction nozzle 65 mounts the component on the board.

### (Acceleration Acquisition Member)

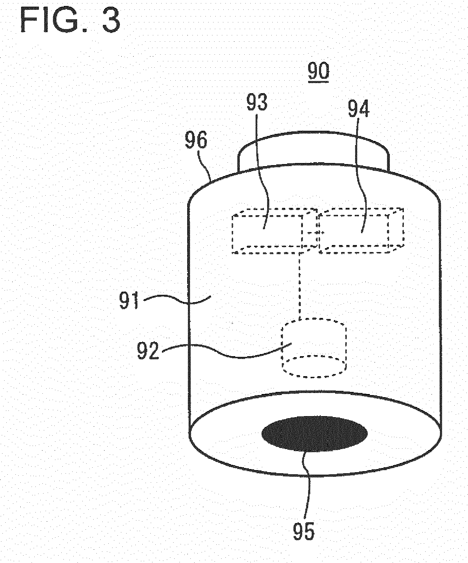

Hereinafter, an acceleration acquisition member 90 will be described with reference to Fig. 3. The acceleration acquisition member 90 is configured to include a main body 91, an acceleration sensor 92, a communication section 93, a battery 94, and a magnet 95. The main body 91 has a block shape. In the present embodiment, the main body 91 has a substantially columnar shape. A mounting surface 96 which is a plane is formed on an upper portion of the main body 91.

The acceleration sensor 92 is attached to the main body 91, and is connected to the communication section 93. The communication section 93 is connected to the control section 50 so as to be communicable therebetween wirelessly or through wired communication, and transmits a detection signal of the acceleration detected by the acceleration sensor 92 to the control section 50. The battery 94 is connected to the communication section 93, and supplies electric power to the communication section 93.

Instead of the suction nozzle 65 illustrated in Fig. 2, the acceleration acquisition member 90 is mounted on the nozzle holder 61. Specifically, the mounting surface 96 of the acceleration acquisition member 90 is arranged so as to oppose the nozzle mounting section 615 of the nozzle holder 61, the mounting surface 96 is sucked by the nozzle suction hole 616 of the nozzle mounting section 615, and the acceleration acquisition member 90 is mounted on the nozzle holder 61. The acceleration acquisition member 90 is adapted to be accommodated in the accommodating portion 70a of the nozzle accommodating member 70.

### (First Natural Frequency Acquisition Process in First Embodiment)

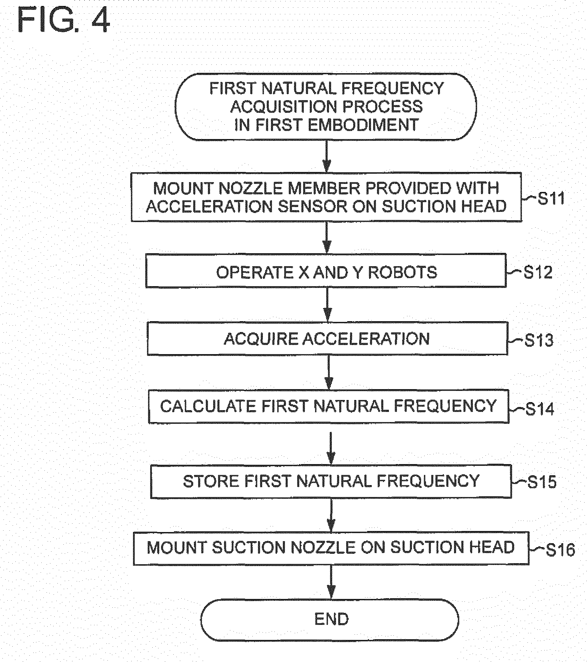

Hereinafter, a "first natural frequency acquisition process in the first embodiment" will be described with reference to a flowchart illustrated in Fig. 4. The "first natural frequency acquisition process" is a process for acquiring "first natural frequency" representing natural frequency of a site (suction nozzle 65) of the suction head 60, which is generated when the XY robots are operated. The acceleration acquisition member 90 is accommodated in the accommodating portion 70a of the nozzle accommodating member 70. If the "first natural frequency acquisition process in the first embodiment" starts, a program proceeds to S11.

In S11, the control section 50 moves the X and Y robots, and moves the suction head 60 onto the nozzle accommodating member 70. Next, the control section 50 causes the imaging device 67 to recognize the accommodating portion 70a which does not accommodate the suction nozzle 65 or the acceleration acquisition member 90, among the accommodation portions 70a of the nozzle accommodating member 70, and causes the accommodating portion 70a to accommodate the suction nozzle 65 mounted on the nozzle holder 61 after detaching the suction nozzle 65 therefrom. Next, the control section 50 causes the imaging device 67 to recognize the acceleration acquisition member 90 accommodated in the accommodating portion 70a, and mounts the acceleration acquisition member 90 on the nozzle holder 61. If S11 is completed, the program proceeds to S12.

In S12, the control section 50 operates the X and Y robots so as to vibrate a site (site of the suction nozzle 65) of the suction head 60. In S13, based on a detection signal transmitted from the acceleration sensor 92, the control section 50 acquires acceleration of the site (site of the suction nozzle 65) of the suction head 60. If S13 is completed, the program proceeds to S14.

In S14, based on the acceleration of the site (site of the suction nozzle 65) of the suction head 60 which is acquired in S13, the control section 50 analyzes vibrations of the site (site of the suction nozzle 65) of the suction head 60 which are generated by a reaction force in response to the movement of the suction head 60, and calculates the "first natural frequency" representing the natural frequency of the site (site of the suction nozzle 65) of the suction head 60. If S14 is completed, the program proceeds to S15.

In S15, the control section 50 causes the "memory section" to store the "first natural frequency" calculated in S14. If S15 is completed, the program proceeds to S16.

In S16, the control section 50 operates the X and Y robots so as to move the suction head 60 onto the nozzle accommodating member 70. Next, the control section 50 causes the imaging device 67 to recognize the accommodating portion 70a which does not accommodate the suction nozzle 65 or the acceleration acquisition member 90, among the accommodation portions 70a of the nozzle accommodating member 70, and causes the accommodating portion 70a to accommodate the acceleration acquisition member 90 mounted on the nozzle holder 61 after detaching the acceleration acquisition member 90 therefrom. Next, the control section 50 causes the imaging device 67 to recognize the suction nozzle 65 accommodated in the accommodating portion 70a, and mounts the suction nozzle 65 on the nozzle holder 61. If S16 is completed, the "first natural frequency acquisition process" is completed.

### (First Natural Frequency Acquisition Process in Second Embodiment)

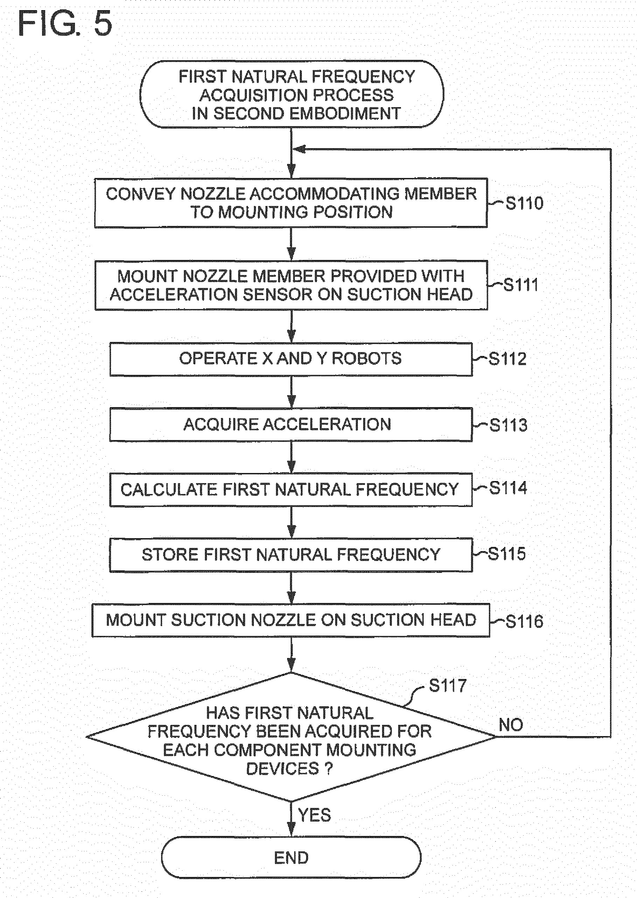

Hereinafter, a "first natural frequency acquisition process in a second embodiment" will be described with reference to a flowchart illustrated in Fig. 5. The "first natural frequency acquisition process in the second embodiment" is a process for acquiring "first natural frequency" of the respective component mounting devices 100 by causing the board conveyance device 10 to sequentially convey the acceleration acquisition member 90 accommodated in the accommodating portion 70a of the nozzle accommodating member 70 to a mounting position inside the component mounting device 100. If the "first natural frequency acquisition process in the second embodiment" starts, the program proceeds to S110.

In S110, the control section 50 operates the board conveyance device 10 so as to convey the nozzle accommodating member 70 to the mounting position inside the component mounting device 100, and then stops the board conveyance device 10. If S110 is completed, the program proceeds to S111.

Processes in S111, S112, S113, S114, S115, and S116 are respectively the same as the processes in S11, S12, S13, S14, S15, and S16 representing the "first natural frequency acquisition process in the first embodiment" illustrated in Fig. 4. If S116 is completed, the program proceeds to S117.

In S117, when determining that the "first natural frequency" for each component mounting devices 100 is acquired (S117: YES), the control section 50 completes the "second natural frequency acquisition process in the first embodiment" . When the control section 50 determines that the "first natural frequency" for each component mounting devices 100 is not acquired (S117: NO), the program returns to S110.

### (Second Natural Frequency Acquisition Process in First Embodiment)

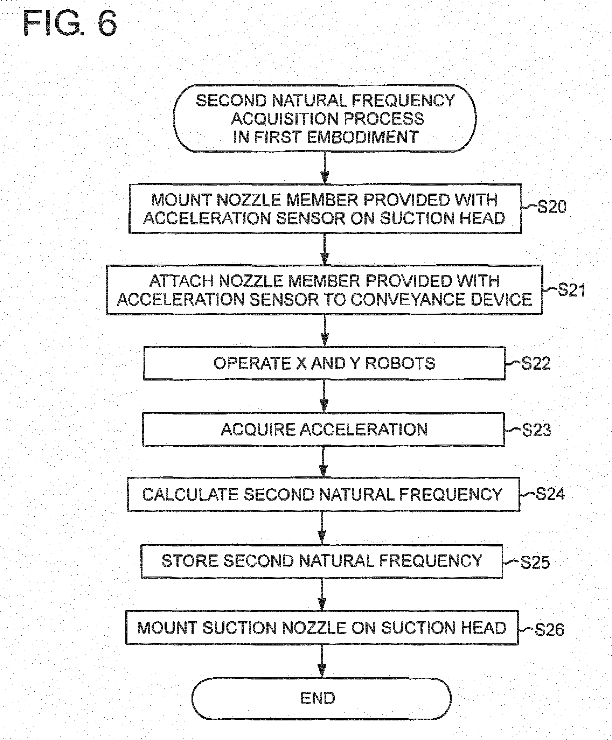

Hereinafter, a "second natural frequency acquisition process in the first embodiment" will be described with reference to a flowchart illustrated in Fig. 6. The "second natural frequency acquisition process" is a process for acquiring "second natural frequency" representing natural frequency of a site (site of the base 41) of the board conveyance device 10, that is, natural frequency on the base 41 side, which is generated when the XY robots are operated. If the "second natural frequency acquisition process in the first embodiment" starts, the program proceeds to S20. A process in S20 is the same as the process in S11 of the "first natural frequency acquisition process" illustrated in Fig. 4. If S20 is completed, the program proceeds to S21.

In S21, the control section 50 operates the X and Y robots, causes the imaging device 67 to confirm a position of the attachment portion 12, moves the suction head 60 onto the attachment portion 12, and places the acceleration acquisition member 90 mounted on the nozzle holder 61 on the attachment portion 12. The attachment portion 12 is formed of a soft magnetic material. Accordingly, the magnet 95 of the acceleration acquisition member 90 is sucked by the attachment portion 12, and the acceleration acquisition member 90 is attached to the attachment portion 12. If S21 is completed, the program proceeds to S22.

In S22 , the control section 50 operates the X and Y robots so as to vibrate the suction head 60, thereby vibrating a site (site of the base 41) of the board conveyance device 10. In S23, based on a detection signal transmitted from the acceleration sensor 92, the control section 50 acquires the acceleration of a site (site of the base 41) of the board conveyance device 10. If S23 is completed, the program proceeds to S24.

In S24, based on the acceleration of the site (site of the base 41) of the board conveyance device 10 which is acquired in S23, the control section 50 analyzes vibrations of the site (site of the base 41) of the board conveyance device 10 which are generated by a reaction force in response to the movement of the suction head 60, and calculates the "second natural frequency" representing the natural frequency of the site (site of the base 41) of the board conveyance device 10. If S24 is completed, the program proceeds to S25.

In S25, the control section 50 causes the "memory section" to store the "second natural frequency" calculated in S24. If S25 is completed, the program proceeds to S26.

A process in S26 is the same as the process in S16 of the "first natural frequency acquisition process" illustrated in Fig. 4. If S26 is completed, the "second natural frequency acquisition process in the first embodiment" is completed.

### (Second Natural Frequency Acquisition Process in Second Embodiment)

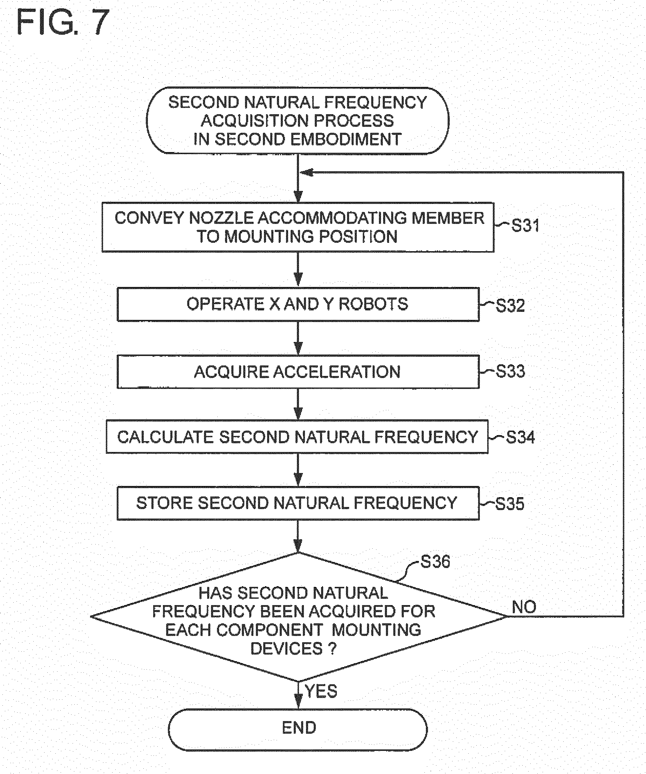

Hereinafter, a "second natural frequency acquisition process in the second embodiment" will be described with reference to a flowchart illustrated in Fig. 7. The "second natural frequency acquisition process in the second embodiment" is a process for acquiring "second natural frequency" of the respective component mounting devices 100 by causing the board conveyance device 10 to sequentially convey the acceleration acquisition member 90 accommodated in the accommodating portion 70a of the nozzle accommodating member 70 to a mounting position inside the component mounting device 100. The nozzle accommodating member 70 accommodating the acceleration acquisition member 90 is placed on a conveyance plate (not illustrated), and the conveyance plate is sequentially conveyed to a mounting position inside the component mounting device 100 by the board conveyance device 10. If the "second natural frequency acquisition process in the second embodiment" starts, the program proceeds to S31.

In S31, the control section 50 operates the board conveyance device 10 so as to convey the nozzle accommodating member 70 to the mounting position inside the component mounting device 100, and then stops the board conveyance device 10. If S31 is completed, the program proceeds to S32.

In S32, the control section 50 operates the X and Y robots so as to vibrate the suction head 60, thereby vibrating a site (site of the base 41) of the board conveyance device 10. In S33, based on a detection signal transmitted from the acceleration sensor 92, the control section 50 acquires the acceleration of a site (site of the base 41) of the board conveyance device 10. If S33 is completed, the program proceeds to S34.

In S34, based on the acceleration of the site (site of the base 41) of the board conveyance device 10 which is acquired in S33, the control section 50 analyzes vibrations of the site (site of the base 41) of the board conveyance device 10 which are generated by a reaction force in response to the movement of the suction head 60, and calculates the "second natural frequency" representing the natural frequency of the site (site of the base 41) of the board conveyance device 10. If S34 is completed, the program proceeds to S35.

In S35, the control section 50 causes the "memory section" to store the "second natural frequency" calculated in S34. If S35 is completed, the program proceeds to S36.

In S36, when determining that the "second natural frequency" for each component mounting devices 100 is acquired (S36: YES), the control section 50 completes the "second natural frequency acquisition process in the second embodiment". When the control section 50 determines that the "second natural frequency" for each component mounting devices 100 is not acquired (S36: NO), the program returns to S31.

### (Vibration Suppressing Section)

Next, "vibration suppressing control" will be described with reference to a block diagram of a vibration suppressing section 200 illustrated in Fig. 8. The "vibration suppressing control" is control for suppressing vibrations generated due to a reaction force in response to the suction head 60 being moved by operating the X and Y robots. As illustrated in Fig. 8, the vibration suppressing section 200 has a position command section 51, a vibration suppressing control section 52, and a feedback control section 53. The position command section 51, the vibration suppressing control section 52, and the feedback control section 53 are configured to include a program stored in the CPU of the control section 50 or the "memory section". However, all of these may be configured to include an application specific integrated circuit (ASIC).

The position command section 51 outputs a "position command" for operating the X and Y robots. The vibration suppressing control section 52 is configured to include a torque control section 52a and a position control section 52b. Based on the "position command" , the "first natural frequency" , and the "second natural frequency", the torque control section 52a outputs a "feed-forward torque command" to the X-servo amplifier 48 and the Y-servo amplifier 49 so as to reduce the "first natural frequency" representing the vibrations of the site (site of the suction nozzle 65) of the suction head 60 and the "second natural frequency" representing the vibrations of the site (site of the base 41) of the board conveyance device 10.

Based on the "position command", the "first natural frequency", and the "second natural frequency", the position control section 52b outputs a "feed-forward position command" to the feedback control section 53 so as to reduce the "first natural frequency" and the "second natural frequency".

Based on the "feed-forward position command" and a "feedback signal" (position signal) output from the X-servo motor 46 and the Y-servo motor 44, the feedback control section 53 outputs a "feedback torque command" to the X-servo amplifier 48 and the Y-servo amplifier 49 respectively so that each position of the X-servo motor 46 and the Y-servo motor 44 becomes a position of the "feed-forward position command".

Based on a "torque command" including the "feed-forward torque command" and the "feedback torque command" , the X-servo amplifier 48 and the Y-servo amplifier 49 generate drive current to be supplied to the X-servo motor 46 and the Y-servo motor 44.

The X-servo motor 46 and the Y-servo motor 44 are operated in accordance with the drive current supplied from the X-servo amplifier 48 and the Y-servo amplifier 49. In addition, the X-servo motor 46 and the Y-servo motor 44 output the "feedback signal" to the feedback control section 53.

### (Advantageous Effects of Present Embodiments)

As is apparent from the above-description, the acceleration acquisition member 90 (acceleration acquisition section) illustrated in Fig. 3 acquires the acceleration of the site of the suction head 60 when the suction head 60 (suction section) is moved by the X and Y robots (suction section moving devices) (S13 in Fig. 4). In this manner, in S14 in Fig. 4, the control section 50 analyzes the acceleration of the site of the suction head 60. Accordingly, it is possible to obtain information which is helpful in suppressing the vibrations of the suction head 60, such as the "first natural frequency" representing the natural frequency of the site of the suction head 60.

In the related art, the position control is performed for the X-servo motor 46 and the Y-servo motor 47 of the X and Y robots by means of feedback control. In a case of vibration components which respond to the "feedback signal" of the servo control of the X-servo motor 46 and the Y-servo motor 47, the vibrations thereof can be suppressed by means of the feedback control. However, due to the vibration components which are not fed back to an encoder of the Y-servo motor 47 of the X-servo motor 46, the position control of the Y-servo motor 47 of the X-servo motor 46 becomes poor. Therefore, in the related art, while the vibrations of the suction head 60 are confirmed, the component mounting device 100 is adjusted so that the suction head 60 does not vibrate when the X and Y robots are operated. Consequently, an enormous amount of time is required for carrying out adjustment work.

According to the present embodiments, as described above, the acceleration acquisition member 90 can easily obtain information which is helpful in suppressing the vibrations of the suction head 60 such as the "first natural frequency". Therefore, based on the information, it is possible to suppress the vibrations of the suction head 60.

In addition, the acceleration acquisition member 90 is attached to the suction head 60 so as to be replaceable with the suction nozzle 65. In this manner, in place of the suction nozzle 65, the acceleration acquisition member 90 is attached to the suction head 60. Accordingly, it is possible to easily acquire the acceleration of the site of the suction head 60.

In recent years, there has been a need for a user to mount various types of electronic components on a board by using a single component mounting device 100. Therefore, the component mounting device 100 corresponds to the various types of electronic components by replacing the existing one with the suction head 60 or the suction nozzle 65 corresponding to the type of electronic components. Here, the vibration components which do not respond to the above-described "feedback signal" vary depending on each type of the suction head 60. In addition, the vibration components vary depending on the floor for mounting the component mounting device 100 or the height of the component mounting device 100. Therefore, when the component mounting device 100 is adjusted, all conceivable vibration components are presumed to adjust the component mounting device 100. Consequently, an enormous amount of time is required for carrying out adjustment work.

According to the present embodiments, even when the type of the suction head 60, the floor for mounting the component mounting device 100, or the height of the component mounting device 100 is changed, the acceleration acquisition member 90 is attached to the suction head 60 in place of the suction nozzle 65 as described above. Accordingly, it is possible to easily acquire the acceleration of the site of the suction head 60. Then, based on the acceleration of the site of the suction head 60, it is possible to obtain information which is useful in suppressing the vibrations of the suction head 60 such as the "first natural frequency". Based on the information, it is possible to suppress the vibrations of the suction head 60. Therefore, an enormous amount of time is not required for carrying out adjustment work.

When the vibration components are changed during the operation period of the component mounting device 100, the acceleration acquisition member 90 is periodically attached to the suction head 60 in place of the suction nozzle 65. In this manner, it is possible to obtain information which is useful in suppressing the vibrations of the suction head 60 such as the "first natural frequency". Based on the information, it is possible to suppress the vibrations of the suction head 60.

In addition, the acceleration acquisition member 90 is detachably attached to the attachment portion 12 which is a member integrally attached to the base 41. In this manner, it is possible to easily attach the acceleration acquisition member 90 to the attachment portion 12 by operating the X and Y robots (S21 in Fig. 6). Therefore, it is possible to easily acquire the acceleration on the base 41 side when the suction head 60 is moved (S23 in Fig. 6). Then, the control section 50 analyzes the acceleration on the base 41 side in S24 in Fig. 6. In this manner, it is possible to obtain information which is useful in suppressing the vibrations of the suction head 60 such as the "second natural frequency" representing the natural frequency on the base 41 side. Then, based on the "second natural frequency" together with the "first natural frequency", the vibration suppressing section 200 (refer to Fig. 8) can perform control for further suppressing the vibrations of the suction head 60.

In addition, the board conveyance device 10 can convey the acceleration acquisition member 90. In this manner, the board conveyance device 10 conveys the acceleration acquisition member 90 so as to stop at the mounting position inside the component mounting device 100 (S31 in Fig. 7), and the suction head 60 is moved by the X and Y robots (S32 in Fig. 7). Accordingly, it is possible to easily acquire the acceleration on the base 41 side when the suction head 60 is moved (S33 in Fig. 7). Then, the control section 50 analyzes the acceleration on the base 41 side in S34 in Fig. 7. In this manner, it is possible to obtain information which is useful in suppressing the vibrations of the suction head 60 such as the "second natural frequency" representing the natural frequency on the base 41 side. Then, based on the "second natural frequency" together with the "first natural frequency" , the vibration suppressing section 200 (refer to Fig. 8) can perform control for further suppressing the vibrations of the suction head 60.

In addition, in the "first natural frequency acquisition process in the second embodiment" illustrated in Fig. 5, the acceleration acquisition member 90 is sequentially conveyed to the component mounting device 100 located on the downstream side by the board conveyance device 10 (S110 in Fig. 5). The acceleration acquisition member 90 is mounted on the suction head 60 by the respective component mounting devices 100 (S111 in Fig. 5), thereby acquiring the "first natural frequency" of the respective component mounting devices 100 (S114 in Fig. 5).

As described above, the acceleration acquisition member 90 is sequentially conveyed to the component mounting device 100 located on the downstream side by the board conveyance device 10. Therefore, it is possible to acquire the "first natural frequency" or the "second natural frequency" of the component mounting device 100 within a short time.

In addition, in S14 in Fig. 4, when the suction head 60 is moved, the control section 50 (vibration analysis section) analyzes the vibrations generated by a reaction force in response to the movement of the suction head 60, and calculates the "first natural frequency" based on the acceleration acquired by the acceleration acquisition member 90. Then, based on the "first natural frequency", the vibration suppressing section 200 illustrated in Fig. 8 controls the X and Y robots (suction section moving devices). In this manner, it is possible to suppress the vibrations of the suction head 60 in response to the movement of the suction head 60.

In addition, in S15 in Fig. 4, the "first natural frequency" is stored in the "memory section". In this manner, it is no longer necessary to calculate the "first natural frequency", based on the acceleration detected by the acceleration acquisition member 90, each time the component mounting device 100 is operated again. Similarly, in S25 in Fig. 6 and S35 in Fig. 7, the "second natural frequency" is stored in the "memory section". In this manner, whenever the component mounting device 100 is operated again, it is no longer necessary to calculate the "second natural frequency", based on the acceleration detected by the acceleration acquisition member 90.

### (Another Embodiment)

According to the embodiments described above, the "first natural frequency" or the "second natural frequency" is calculated. However, the embodiments may adopt a configuration as described below. That is, without calculating the "first natural frequency" or the "second natural frequency", the X and Y robots repeatedly perform a positioning operation of the suction head 60. Based on the acceleration of the site of the suction head 60, which is detected by the acceleration acquisition member 90, the vibrations of the suction head 60 are suppressed by adjusting a program of the control section 50.

According to the embodiments described above, the "acceleration acquisition section" which acquires the acceleration of the site of the suction head 60 is the acceleration acquisition member 90 which is attached to the nozzle holder 61 of the suction head 60 so as to be replaceable with the suction nozzle 65. However, the "acceleration acquisition section" may be the acceleration acquisition member 190 which is attached to the X-axis slide 45 (suction section moving device) so as to be replaceable with the suction head 60.

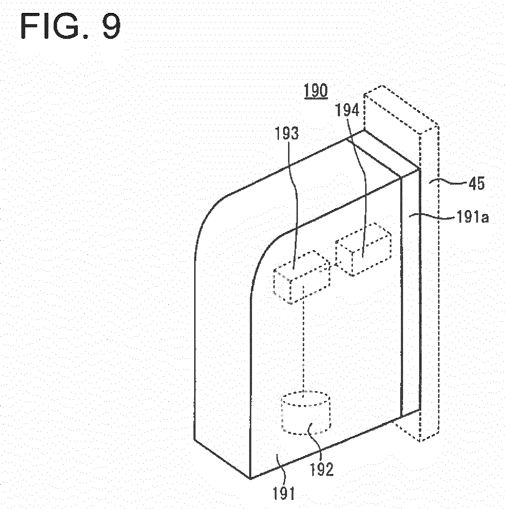

As illustrated in Fig. 9, an acceleration acquisition member 190 is configured to include a main body 191, an acceleration sensor 192, a communication section 193, and a battery 194. The main body 191 has a block shape, and has a detachably attached portion 191a which is detachably attached to the X-axis slide 45 by using a screw. The acceleration sensor 192, the communication section 193, and the battery 194 are respectively the same as the acceleration sensor 92, the communication section 93, and the battery 94 of the acceleration acquisition member 90 illustrated in Fig. 3.

As described above, in place of the suction head 60, the acceleration acquisition member 190 (acceleration acquisition section) is attached to the X-axis slide 45 (suction section moving device). In this manner, it is possible to easily acquire the acceleration of the site of the suction head 60.

According to the embodiments described above, the acceleration acquisition member 90 does not function as the suction nozzle 65. However, an embodiment may be adopted in which the acceleration sensor 92, the communication section 93, and the battery 94 are attached to the suction nozzle 65. Similarly, an embodiment may be adopted in which the acceleration sensor 192, the communication section 193, and the battery 194 are attached to the suction head 60.

According to the embodiments described above, based on the "first natural frequency" and the "second natural frequency" , the vibration suppressing section 200 illustrated in Fig. 8 performs feed-forward control so as to reduce the "first natural frequency" and the "second natural frequency". However, an embodiment may be adopted in which based on only the "first natural frequency", the vibration suppressing section 200 performs the feed-forward control so as to reduce the "first natural frequency".

According to the embodiments described above, in S21 in Fig. 6, the magnet 95 of the acceleration acquisition member 90 sucks the attachment portion 12, and the acceleration acquisition member 90 is attached to the attachment portion 12. However, an embodiment may be adopted in which an engagement recessed portion with which a lower portion of the acceleration acquisition member 90 engages is formed on an upper surface of the attachment portion 12 so that the acceleration acquisition member 90 is attached to the attachment portion 12. In a case of this embodiment, it is not necessary to dispose the magnet 95 in the acceleration acquisition member 90.

According to the embodiments described above, the attachment portion 12 is attached to the board conveyance device 10. However, an embodiment may be adopted in which the attachment portion 12 is attached to the base 41 or a member which is integrally attached to the base 41.

### Reference Signs List

10 ... BOARD CONVEYANCE DEVICE, 12 ... ATTACHMENT PORTION (MEMBER INTEGRALLY ATTACHED TO BASE), 41 ... BASE, 42 ... GUIDE RAIL (SUCTION SECTION MOVING DEVICE), 43 ... Y-AXIS SLIDE (SUCTION SECTION MOVING DEVICE), 44 ... Y-SERVO MOTOR (SUCTION SECTION MOVING DEVICE), 45 ... X-AXIS SLIDE (SUCTION SECTION MOVING DEVICE), 46 ... X-SERVO MOTOR (SUCTION SECTION MOVING DEVICE), 48 ... X-SERVO AMPLIFIER (SUCTION SECTION MOVING DEVICE), 49 ... Y-SERVO AMPLIFIER (SUCTION SECTION MOVING DEVICE), 60 ... SUCTION HEAD (SUCTION SECTION), 65 ... SUCTION NOZZLE (SUCTION SECTION), 90 ... ACCELERATION ACQUISITION MEMBER (ACCELERATION ACQUISITION SECTION), 190 ... ACCELERATION ACQUISITION MEMBER

(ACCELERATION ACQUISITION SECTION)

## Claims

1. A component mounting device comprising:
a base (41);
a suction section (60, 65) that sucks a component, and that mounts the component on a board;
a suction section (60, 65) moving device that is provided on the base (41), and that moves the suction section (60, 65); and
an acceleration acquisition section (90) that acquires acceleration of a site of the suction section (60, 65) when the suction section (60, 65) moving device moves the suction section (60, 65);
wherein the suction section (60, 65) is configured to include a suction nozzle (65) which sucks the component and a suction head (60) which is attached to the suction section (60, 65) moving device by attaching the suction nozzle (65) thereto,
**characterized in that**
the acceleration acquisition section (90) is attached to the suction head (60) in place of the suction nozzle (65) or to the suction section (60, 65) moving device in place of the suction head (60).

2. The component mounting device according to Claim 1,
wherein the acceleration acquisition section (90) is detachably attached to the base (41) or a member (21) which is integrally attached to the base (41).

3. The component mounting device according to Claim 1,
wherein a board conveyance device (10) which conveys the board is provided on the base (41), and
wherein the board conveyance device (10) can convey the acceleration acquisition section (90).

4. The component mounting device according to any one of Claims 1 to 3, further comprising:
a vibration analysis section (50) that analyzes vibrations generated by the movement of the suction section (60, 65), based on acceleration acquired by the acceleration acquisition section (90), when the suction section (60, 65) moving device moves the suction section (60, 65); and
a vibration suppressing section (200) that controls the suction section (60, 65) moving device so as to suppress the vibrations, based on a result of analysis performed by the vibration analysis section (50).

## Patentansprüche

1. Bauteil-Montagevorrichtung, die umfasst:
einen Sockel (41);
einen Ansaug-Teilabschnitt (60, 65), der ein Bauteil ansaugt und das Bauteil an einer Platte montiert;
eine Vorrichtung zum Bewegen des Ansaug-Teilabschnitts (60, 65), die sich an dem Sockel (41) befindet und die den Ansaug-Teilabschnitt (60, 65) bewegt; sowie
einen Abschnitt (90) zur Erfassung von Beschleunigung, der Beschleunigung einer Position des Ansaug-Teilabschnitts (60, 65) erfasst, wenn die Vorrichtung zum Bewegen des Ansaug-Teilabschnitts (60, 65) den Ansaug-Teilabschnitt (60, 65) bewegt;
wobei der Ansaug-Teilabschnitt (60, 65) so ausgeführt ist, dass er eine Ansaug-Düse (65), die das Bauteil ansaugt, und einen Ansaug-Kopf (60) enthält, der an der Vorrichtung zum Bewegen des Ansaug-Teilabschnitts (60, 65) angebracht wird, indem die Ansaug-Düse (65) daran angebracht wird,
**dadurch gekennzeichnet, dass**
der Abschnitt (90) zur Erfassung von Beschleunigung anstelle der Ansaug-Düse (65) an dem Ansaug-Kopf (60) oder anstelle des Ansaug-Kopfes (60) an der Vorrichtung zum Bewegen des Ansaug-Teilabschnitts (60, 65) angebracht wird.

2. Bauteil-Montagevorrichtung nach Anspruch 1,
wobei der Teilabschnitt (90) zur Erfassung von Beschleunigung abnehmbar an dem Sockel (41) oder einem Element (21) angebracht wird, das integral an dem Sockel (41) angebracht ist.

3. Bauteil-Montagevorrichtung nach Anspruch 1,
wobei eine Platten-Transportvorrichtung (10), die die Platte transportiert, an dem Sockel (41) vorhanden ist, und
die Platten-Transportvorrichtung (10) den Teilabschnitt (90) zur Erfassung von Beschleunigung transportieren kann.

4. Bauteil-Montagevorrichtung nach einem der Ansprüche 1 bis 3, die des Weiteren umfasst:
einen Teilabschnitt (50) zur Analyse von Schwingungen, der durch die Bewegung des Ansaug-Teilabschnitts (60, 65) erzeugte Schwingungen auf Basis von Beschleunigung analysiert, die durch den Teilabschnitt (90) zur Erfassung von Beschleunigung erfasst wird, wenn die Vorrichtung zum Bewegen des Ansaug-Teilabschnitts (60, 65) den Ansaug-Teilabschnitt (60, 65) bewegt;
einen Teilabschnitt (200) zur Unterdrückung von Schwingungen, der die Vorrichtung zum Bewegen des Ansaug-Teilabschnitts (60, 65) auf Basis eines Ergebnisses durch den Teilabschnitt (50) zur Analyse von Schwingungen durchgeführter Analyse so steuert, dass die Schwingungen unterdrückt werden.

## Revendications

1. Dispositif de montage de composants comprenant :
une base (41),
une section d'aspiration (60, 65) qui aspire un composant et qui monte le composant sur une carte,
un dispositif de déplacement de section d'aspiration (60, 65) qui est prévu sur la base (41) et qui déplace la section d'aspiration (60, 65), et
une section d'acquisition d'accélération (90) qui acquiert l'accélération d'un site de la section d'aspiration (60, 65) lorsque le dispositif de déplacement de section d'aspiration (60, 65) déplace la section d'aspiration (60, 65),
dans lequel la section d'aspiration (60, 65) est configurée pour inclure une buse d'aspiration (65) qui aspire le composant et une tête d'aspiration (60) qui est fixée au dispositif de déplacement de section d'aspiration (60, 65) en y fixant la buse d'aspiration (65),
**caractérisé en ce que**
la section d'acquisition d'accélération (90) est fixée à la tête d'aspiration (60) à la place de la buse d'aspiration (65) ou bien au dispositif de déplacement de section d'aspiration (60, 65) à la place de la tête d'aspiration (60).

2. Dispositif de montage de composants selon la revendication 1,
dans lequel la section d'acquisition d'accélération (90) est fixée à la base (41) tout en pouvant être démontée, ou à un élément (21) qui est fixé solidairement à la base (41).

3. Dispositif de montage de composants selon la revendication 1,
dans lequel est prévu sur la base (41) un dispositif de transport de carte (10) qui transporte la carte, et
dans lequel le dispositif de transport de carte (10) peut transporter la section d'acquisition d'accélération (90).

4. Dispositif de montage de composants selon l'une quelconque des revendications 1 à 3, comprenant en outre :
une section d'analyse de vibrations (50) qui analyse les vibrations générées par le mouvement de la section d'aspiration (60, 65) sur la base de l'accélération acquise par la section d'acquisition d'accélération (90) lorsque le dispositif de déplacement de section d'aspiration (60, 65) déplace la section d'aspiration (60, 65), et
une section de suppression de vibrations (200) qui commande le dispositif de déplacement de section d'aspiration (60, 65) de façon à supprimer les vibrations sur la base du résultat de l'analyse effectuée par la section d'analyse de vibrations (50).
